# EUROPEAN PATENT APPLICATION

(11) **EP 2 648 229 A1**
(43) Date of publication of application: **09.10.2013**
(21) Application number: 11845772.0
(22) Date of filing: 22.11.2011
(51) Int. Cl.: H01L 31/042

(54) **SOLAR CELL MODULE AND PRODUCTION METHOD THEREFOR**

(30) Priority: 30.11.2010 JP 2010266754
(71) Applicant: Sanyo Electric Co., Ltd., Osaka 570-8677 (JP)
(72) Inventor: ISHIGURO Tasuku, Moriguchi-shi Osaka 570-8677 (JP)
(74) Representative: Glawe, Delfs, Moll
(86) International application number: PCT/JP2011/076856
(87) International publication number: WO 2012/073751

(57) **Abstract**

[Problem] To provide a solar cell module having improved output and a method that can manufacture that solar cell module.

[Solution] A solar cell module 1 has a colored resin layer 13a and a transparent resin layer 13b laminated onto the colored resin layer 13 a. Solar cells 12 are disposed between the colored resin layer 13a and the transparent resin layer 13b such that back surfaces 12b are oriented toward the colored resin layer 13a side and light receiving surfaces 12a are oriented towards the transparent resin layer 13b side. The solar cell module 1 has bonding by a silane coupling agent between the light receiving surfaces 12a of the solar cells 12 and the transparent resin layer 13b.

## Description

### FIELD OF THE INVENTION

The present invention relates to a solar cell module and a method for manufacturing the same.

### BACKGROUND

In recent years solar cell modules have attracted a great amount of attention as energy sources with low environmental impact.

Solar cell modules are provided with solar cells. Solar cells are easily degraded through contact with moisture and the like. Therefore, solar cells must be isolated from outside air. Therefore, solar cells are normally disposed within filler layers that are provided between protective members to protect the front and back.

With regard to these filler layers, for example, Patent Reference 1 described below states that, of these filler layers, a portion positioned between the back surface of a solar cell and the back surface side protective member is fabricated of a colored EVA film. In addition, Patent Reference 1 states that photoelectric conversion efficiency can be improved because the utilization efficiency of light is increased by using the colored EVA film.

### DOCUMENTS OF PRIOR ART

### [Patent Documents]

Patent Reference 1: Published Unexamined Patent Application No. 2003-258283

### SUMMARY

### Problems to be Solved by the Invention

The solar cell module described in Patent Reference 1 can be manufactured by, for example, thermocompression bonding of a laminate in which solar cells are disposed between a colored EVA film and a transparent EVA film.

However, when the solar cell module described in Patent Reference 1 is manufactured by this manufacturing method, there is concern that the colored EVA will wrap around to the light receiving surface side of the solar cells. If the colored EVA wraps around to the light receiving surface side of the solar cells, part of the light that should be incident to the light receiving surface will be shielded by the colored EVA. Therefore, the output of the solar cell module will be reduced because the light reception efficiency on the light receiving surface is reduced.

### Means to Solve the Problems

A solar cell module according to an embodiment of the present invention has a colored resin layer and a transparent resin layer laminated on top of the colored resin layer. The solar cells are disposed between the colored resin layer and the transparent resin layer with the back surface oriented to the colored resin layer side and the light receiving surface oriented toward the transparent resin layer side. The solar cell module according to the present invention has bonding by a silane coupling agent between the light receiving surface of the solar cells and the transparent resin layer.

A manufacturing method for a solar cell module according to an embodiment of the present invention relates to a manufacturing method for the solar cell module having a colored resin layer and a transparent resin layer. The transparent resin layer is laminated on top of the colored resin layer. Solar cells are disposed at the boundary between the colored resin layer and transparent resin layer with the back surface oriented toward the loop resin layer side and the light receiving surface oriented toward the transparent resin layer side. The manufacturing method for the solar cell module according to an embodiment of the present invention has a silane coupling agent applied to at least one of a transparent resin sheet for constituting the transparent resin layer and the light receiving surface of solar cells. The transparent resin sheet, solar cells, and a colored resin sheet for constituting the colored resin layer are laminated such that the light receiving surface of the solar cells is in contact with one main surface of the transparent resin sheet while the back surface is in contact with the colored resin sheet, and a laminate is fabricated. Thermocompression bonding is carried out to thermocompression bond the laminate.

### EFFECTS OF THE INVENTION

According to the present invention, a solar cell module having improved output and a method that can manufacture that solar cell module are provided.

### BRIEF DESCRIPTION OF THE DRAWINGS

Figure 1 is a schematic cross-sectional view of a solar cell module according to an embodiment of the present invention.
Figure 2 is a schematic cross-sectional view for describing a manufacturing method for the solar cell module according to an embodiment of the present invention.

### DETAILED DESCRIPTION

In the following, an example of a preferred embodiment of the present invention will be described. However, the embodiment described below is only an example. The present invention is not limited in any manner to the following embodiment.

In addition, in the drawings referred to in the following embodiment, members having substantially the same function are referred to by the same element numbers. In addition, the figures referred to in the embodiment are denoted schematically, and the proportions of dimensions of objects drawn in the drawings and the like may differ from the proportions of dimensions of actual objects. The dimensional proportions and the like of objects may also differ among the drawings. Specifically, dimensional proportions and the like of objects should be judged with allowance made for the following description.

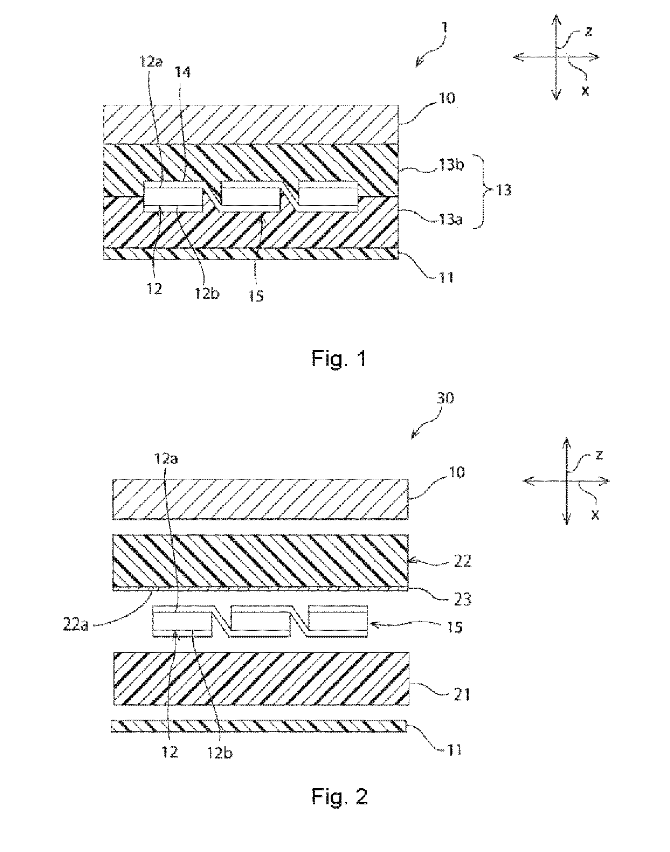

Figure 1 is a schematic cross-sectional view of the solar cell module according to the present embodiment.

A solar cell module 1 comprises a first protective member 10, a second protective member 11, a filler layer 13 as a resin layer, and solar cell strings 15. The solar cell module 1 may have a frame that surrounds the periphery thereof. In addition, there may be a terminal box for extracting electric power on a front surface of a second protective member 12.

### (Light receiving surface side protective member 10 and back surface side protective member 11)

The first protective member 10 is disposed on the light receiving surface of the solar cell module 1. The first protective member 10 is a member that secures mechanical strength for the solar cell module 1. Therefore, the protective member 10 is preferably a member having transparency and rigidity. The protective member 10 can be constituted of a glass sheet, resin sheet, or the like. Among these, the protective member 10 is preferably constituted of a glass sheet. This is because a glass plate has high rigidity and light transmission as well as superior weatherability. The thickness of the first protective member 10 is not limited in particular. The thickness of the protective member 10 is, for example, when a glass sheet is used, roughly 3 mm - 6 mm.

The second protective member 11 faces the first protective member 10. The second protective member 11 is disposed on the back surface of the solar cell module 1. The second protective member 11 can, for example, be constituted of a resin sheet formed from polyethylene terephthalate (PET) or the like. Moreover, within the resin sheet constituting the protective member 11, for example, a metal foil such as aluminum foil, an inorganic barrier layer with low moisture permeability, or the like may be provided. The inorganic barrier layer can, for example, be formed of an inorganic oxide such as silicon oxide, aluminum oxide, magnesium oxide, and the like. Moreover, the thickness of the second protective member 11 is not limited in particular. The thickness of the protective member 11 can be, for example, when a resin sheet is used, roughly 150 µm - 300 µm.

### (Solar cell strings 15)

A plurality of solar cell strings 15 is disposed within the filler layer 13. Specifically, the solar cell strings 15 are provided with a plurality of solar cells 12. The plurality of solar cells 12 is arranged in one direction and is electrically connected in series or parallel by wiring material 14. Specifically, the plurality of solar cells 12 are electrically connected in series or parallel by the solar cells 12 that are arranged in a single direction and adjacent to each other being electrically connected by the wiring material 14. In the present embodiment, the wiring material 14 electrically connects an electrode disposed on a light receiving surface 12a of one of the solar cells 12 that are adjacent to each other and an electrode disposed on a back surface 12b of the other.

Moreover, in the present invention, the solar cells may be back surface joining type solar cells in which both a p side electrode and an n side electrode are disposed on the back surface. In such a case, the wiring material 14 electrically connects the p side electrode on one solar cell of solar cells that are adjacent to each other and the n side electrode on the other solar cell.

### (Filler layer 13)

The filler layer 13 is filled in between the first protective member 10 and the second protective member 11. A plurality of solar cell strings 15 is disposed within the filler layer 13. In other words, the filler layer 13 is a member for sealing the solar cell strings 15. Therefore, the filler layer 13 may also be referred to as a sealing layer.

Specifically, the filler layer 13 is constituted of a laminate that includes a colored resin layer 13a and a transparent resin layer 13b. The colored resin layer 13a is disposed on the second protective member 11 side of the solar cells 12. The transparent resin layer 13b is disposed on the first protective member 10 side of the solar cells 12. In the solar cell module 1, the colored resin layer 13a, and the transparent resin layer 13b are disposed so as to be adjacent to each other. The solar cell strings 15 are disposed in the interface between the colored resin layer 13a and the transparent resin layer 13b. The solar cell strings 15 are disposed such that a light receiving surface 12a is oriented toward the transparent resin layer 13b side and a back surface 12b is oriented toward the colored resin layer 13a side.

Moreover, in the present embodiment, the filler layer 13 for the resin layer is constituted of a laminate of the colored resin layer 13a and the transparent resin layer 13b. However, in the present invention, the resin layers are not limited in particular other than having a colored resin layer positioned on the back surface side and a transparent resin layer positioned on the light receiving side and adjacent to the colored resin layer. The resin layers may have a resin layer other than the colored resin layer and the transparent resin layer. In addition, the colored resin layer and transparent resin layer may each be constituted of a plurality of resin layers.

### (Transparent resin layer 13b)

The transparent resin layer 13b is disposed between the light receiving surface 12a of the solar cells 12 and the first protective member 10. Here, the transparent resin layer 13b is a resin layer that transmits light in a wavelength range used in photoelectric conversion in the solar cells 12. The transparent resin layer 13b preferably has average light transmittance of 85% or greater in a wavelength range of 400 nm - 1100 nm.

The transparent resin layer 13b is at least one type of resin out of ethylene-vinyl acetate copolymer (EVA), polyvinyl butyral (PVB), ethylene vinyl alcohol copolymer, acrylic resin, polyethylene (PE) and polypropylene (PP) or a resin composition containing at least one type of resin out of those resins.
From the standpoint of suitably protecting the solar cell strings 15, the transparent resin layer 13b preferably is a cured resin having a crosslinked structure.

The solar cell module 1 is bonded with a silane coupling agent between the transparent resin layer 13b and the light receiving surfaces 12a of the solar cells 12.

### (Colored resin layer 13a)

The colored resin layer 13a is disposed between the back surface 12b and the second protective member 11. The colored resin layer 13a is formed from a resin composition that includes a colorant. Specific examples of the colorant include, for example, white colorants such as titanium oxide particles and calcium carbonate particles, blue colorants such as ultramarine, black colorants such as carbon black, coloring agents that give the colored resin layer 13a a milky white color such as glass beads and light scattering materials, and the like. Among these, white titanium oxide particles are preferably used. Light becomes easily scattered in the colored resin layer 13a by including white titanium oxide particles in the colored resin layer 13a, and the photoelectric conversion efficiency of the solar cell module 1 can be increased further.

The resin included in the colored resin layer 13a can be made to be, for example, at least one type of resin out of ethylene-vinyl acetate copolymer (EVA), polyvinyl butyral (PVB), ethylene vinyl alcohol copolymer, acrylic resin, polyethylene (PE), and polypropylene (PP). The resin included in the colored resin layer 13a may be the same as the resin included the transparent resin layer 13b or may be different.

From the standpoint of suitably protecting the solar cell strings 15, the colored resin layer 13a is preferably also a cured resin having a crosslinked structure identical to the colored resin layer 13b.

### (Manufacturing method for solar cell module 1)

Next, an example of the manufacturing method for the solar cell module 1 will be described with reference to Figure 2.

First, a transparent resin sheet 22 for constituting the colored resin layer 13 a, a colored resin sheet 21 for constituting the colored resin layer 13a, solar cell strings 15, first protective member 10, and second protective member 11 are prepared. The transparent resin sheet 22 and the colored resin sheet 21 are each formed from a resin composition that includes at least one type of resin out of ethylene-vinyl acetate copolymer (EVA), polyvinyl butyral (PVB), ethylene vinyl alcohol copolymer, acrylic resin, polyethylene (PE), and polypropylene (PP), and a crosslinking agent. In addition, the colored resin sheet 21 preferably also includes a colorant as described above.

Specific examples of a preferably used crosslinking agent include, for example, organic peroxides. For example, organic peroxides that crosslink EVA include 2,5-dimethylhexane-2,5-dihydroperoxide, 2,5-dimethyl-2,5-di(t-butylperoxy)hexane, 3-di-t-hydroperoxide, 2,5-dimethyl-2,5-di(t-butylperoxy)hexane, dicumyl peroxide, alpha,alpha'-bis(t-butylperoxy isopropyl)hexane, n-butyl-4,4-bis(t-butylperoxy)butane, 2,2-bis(t-butylperoxy)butane, 1,1-bis(t-butylperoxy) cyclohexane, 1,1-bis(t-butylperoxy)3,3,5-trimethylcyclohexane, t-butyl peroxybenzoate, benzoyl peroxide, and the like.

Next, the first protective member 10, transparent resin sheet 22, solar cell strings 15, colored resin sheet 21, and second protective member 11 are laminated in this order such that the light receiving surfaces 12a are oriented toward the transparent resin sheet 22 side and the back surface 12b is oriented toward the colored resin sheet 21 side, and a laminate 30 is fabricated.

Moreover, prior to the fabrication of this laminate 30, a silane coupling agent is applied to at least one of a main surface 22a on the solar cell string 15 side of the transparent resin sheet 22 and light receiving surfaces 12a of each of the plurality of solar cells 12 constituting the solar cell strings 15, and a silane coupling agent layer 23 is formed. The silane coupling agent may be applied to both the main surface 22a and the light receiving surfaces 12a, may be applied only to the main surface 22a, or may be applied to only the light receiving surfaces 12a. In the following, an example in which the silane coupling agent layer 23 is formed by applying the silane coupling agent to the main surface 22a in the present embodiment will be described.
For the silane coupling agent, for example, aminosilane-based silane coupling agents or epoxysilane-based silane coupling agents can be used preferably, but the silane coupling agent is not limited to these. Specific examples of the aminosilane-based silane coupling agent, include, for example, 3-aminopropyltrimethoxysilane, 3-aminopropyltriethoxysilane, N-2-(aminoethyl)-3-aminopropyltrimethoxysilane, N-2-(aminoethyl)-3-aminopropyltriethoxysilane, N-2-(aminoethyl)-3-aminopropylmethyldimethoxysilane, N-phenyl-3-aminopropyltrimethoxysilane, and the like. In addition, specific examples the epoxy-based silane coupling agent include, for example, 3-glycidoxypropylmethyldimethoxysilane, 3-glycidoxypropylmethyltrimethoxysilane, 3-glycidoxypropylmethyldiethoxysilane, 3-glycidoxypropyltriethoxysilane, and the like. When the silane coupling agent is applied, the application can be carried out using a liquid in which the silane coupling agent is dissolved or dispersed in an organic solvent such as isopropyl alcohol.

Next, the laminate 30 is thermocompression bonded using a laminating method. Moreover, in the present embodiment, the silane coupling agent layer 23 is formed on the main surface 22a on the solar cell string 15 side of the transparent resin sheet 22. Therefore, in this compression bonding process, the silane coupling agent layer 23 is made to adhere rigidly with the transparent resin sheet 22 and light receiving surfaces 12a by a reaction.

Next, a curing process is carried out. The curing process is a process in which a crosslinked structure is formed within the transparent resin sheet 22 and the colored resin sheet 21. Specifically, the crosslinked structure is formed within the transparent resin sheet 22 and colored resin sheet 21 by heating the transparent resin sheet 22 and colored resin sheet 21 and reacting a crosslinking agent contained in the transparent resin sheet 22 and colored resin sheet 21. Thus, the transparent resin sheet 22 and colored resin sheet 21 are cured and the transparent resin layer 13b and colored resin layer 13a are completed.

However, for example, when no silane coupling agent layer is formed, rigid adhesion to the transparent resin sheet and light receiving surface does not occur. Therefore, in the thermocompression bonding process, part of the colored resin sheet positioned on the back surface side may flow to the light receiving side, and may enter between the light receiving surface and transparent resin sheet. In such cases, part of the colored resin layer is positioned on the light receiving surface. Therefore, part of the light trying to be incident to the light receiving surface is shielded by the colored resin layer. Thus, the light receiving efficiency of the light receiving surface is reduced. Therefore, the output of the solar cell module is reduced.

Conversely, in the present embodiment, the silane coupling agent layer 23 is formed prior to the thermocompression bonding process. Therefore, the silane coupling agent layer 23 reacts immediately after the start of the compression bonding process, and bonding is formed between the light receiving surfaces 12a of the solar cells 12 and the transparent resin sheet 22 by the silane coupling agent. Thus, the transparent resin sheet 22 and light receiving surfaces 12a rigidly adhere. Thus, even if part of the colored resin sheet 21 positioned on the back surface 12b side flows to the light receiving surfaces 12a side, the colored resin sheet 21 cannot easily enter between the light receiving surfaces 12a and transparent resin sheet 22. In other words, in the solar cell module 1, the wrapping around of the colored resin layer 13a to the light receiving surfaces 12a of the solar cells 12 is suppressed by the bonding by the silane coupling agent. Therefore, in the manufacturing method of the present embodiment, positioning of part of the colored resin layer on the light receiving surfaces 12a is suppressed. As a result, reductions in the light receiving efficiency of the light receiving surfaces 12a can be suppressed. Therefore, the solar cell module 1 having an improved output can be manufactured.

### (Example)

In the present example, a solar cell module having an identical constitution to the solar cell module 1 according to the first embodiment above was manufactured according to the following outline.

First, a transparent EVA sheet with a thickness of 0.6 mm containing 2% by mass of 1,1-bis (t-butylperoxy)3,3,5-trimethylcyclohexane as a curing agent was disposed on a first protective member 10, which was formed from a glass sheet. Next, an isopropyl alcohol solution containing N-2-(aminoethyl)-3-aminopropyltrimethoxysilane as the silane coupling agent was applied to the surface of the transparent EVA sheet and the silane coupling agent layer 23 was formed. Furthermore, solar cell strings 15, a colored EVA sheet having a thickness of 0.6 mm, containing 2% by mass of 1,1-bis(t-butylperoxy)3,3,5-trimethylcyclohexane as a curing agent, and containing 5% by mass of titanium oxide as a colorant, and a second protective member 11 were laminated in this order on the transparent EVA sheet, and the laminate 30 was fabricated. Next, thermal compression bonding of the laminate 30 was carried out using a laminating method. Thereafter, the solar cell module was completed by introducing a crosslinked structure into the filler layer by holding for approximately one hour at approximately 150°C.

Next, the solar cell module was inspected as to whether the colored resin layer had wrapped around onto the light receiving surface by visual observation from the first protective member 10 side. As a result, none of the colored resin layer had wrapped around onto the light receiving surface in this example.

Furthermore, the output was measured when light with an intensity of 100 mW/cm² at AM 1.5 was made to shine on the solar cell module. The results are given in Table 1 which follows.

### (Comparative Example)

A solar cell module was fabricated identically to the example above with the exception of the silane coupling agent not being applied, and inspection of whether or not the colored resin layer wrapped around to the light receiving surface and output measurements were carried out. In this comparative example, the colored resin layer was found to have wrapped around onto the light receiving surface.

**[Table 1]**

| | Output ratio (%) |
|---|---|
| Example | 100.3 |
| Comparative Example | 100 |

Moreover, the output values in Table 1 above are standardized with the output value for the comparative example set at 100.

From the results of the example and comparative example, it can be seen that the wrapping and forming of the colored resin layer onto the light receiving surface can be suppressed by applying a silane coupling agent to the surface of the transparent resin sheet. In addition, it can be seen that a high output was obtained as shown in Table 1.

### EXPLANATION OF THE ELEMENTS

- 1: Solar cell module
- 10: First protective member
- 11: Second protective member
- 12: Solar cell
- 12a: Light receiving surface
- 12b: Back surface
- 13: Filler layer
- 13a: Colored resin layer
- 13b: Transparent resin layer
- 14: Wiring material
- 15: Solar cell string
- 21: Colored resin sheet
- 22: Transparent resin sheet
- 23: Silane coupling agent layer
- 30: Laminate

## Claims

1. A solar cell module comprising
a colored resin layer,
a transparent resin layer laminated on to the colored resin layer, and
solar cells are disposed between the colored resin layer and transparent resin layer with a back surface oriented toward the colored resin layer side and a light receiving surface oriented toward the transparent resin layer side and
having bonding by a silane coupling agent between the light receiving surface of the solar cells and the transparent resin layer.

2. The solar cell module according to claim 1 wherein:
the colored resin layer is not provided on the light receiving side of the solar cells.

3. The solar cell module according to claim 1 or claim 2 wherein:
the silane coupling agent is an aminosilane-based silane coupling agent.

4. The solar cell module according to claim 1 or claim 2 wherein:
the silane coupling agent is an epoxysilane-based silane coupling agent.

5. The solar cell module according to any one of claims 1 through 4 wherein:
the transparent resin layer contains at least one of an ethylene-vinyl acetate copolymer, polyvinyl butyral, an ethylene vinyl alcohol copolymer, an acrylic resin, polyethylene, and polypropylene.

6. A solar cell module manufacturing method is a method for manufacturing the solar cell module comprising:
a colored resin layer,
a transparent resin layer laminated on to the colored resin, and
solar cells disposed between the colored resin layer and transparent resin layer with the back surface oriented toward the colored resin layer side and the light receiving surface oriented toward the transparent resin layer side, said solar cell module manufacturing method comprising
a step for applying a silane coupling agent to at least one of a transparent resin sheet for constituting the transparent resin layer and a light receiving surface of the solar cells,
a step for laminating the transparent resin sheet, solar cells, and a colored resin sheet for constituting the colored resin layer such that the light receiving surfaces of the solar cells are in contact with one main surface of the transparent resin sheet while the back surfaces are in contact with the colored resin sheet fabricating a laminate, and
a step for thermocompression bonding that thermocompression bonds the laminate.

7. The solar cell manufacturing method according to claim 6 wherein:
the silane coupling agent is an aminosilane-based coupling agent.

8. The solar cell manufacturing method according to claim 6 wherein:
the silane coupling agent is an epoxysilane-based coupling agent.

9. The solar cell manufacturing method according to any one of claims 6 through 8 wherein:
each of the transparent resin sheet and the colored resin sheet contains a resin and a crosslinking agent, and
a curing step that forms crosslinking in the transparent resin sheet and the colored resin sheet is carried out after the thermocompression bonding step

10. The solar cell manufacturing method according to any one of claims 6 through 8 wherein:
the transparent resin sheet contains an ethylene-vinyl acetate copolymer, polyvinyl butyral, an ethylene vinyl alcohol copolymer, an acrylic resin, polyethylene, or polypropylene.
